# NEUE EUROPÄISCHE PATENTSCHRIFT

(11) **EP 3 056 916 B2**
(45) Veröffentlichungstag und Bekanntmachung des Hinweises auf die Entscheidung über den Einspruch: **15.03.2023**
(45) Hinweis auf die Patenterteilung: 06.05.2020
(21) Anmeldenummer: 16153567.9
(22) Anmeldetag: 01.02.2016
(51) Int. Cl.: G01R 31/34, G01R 31/42, G01R 31/55

(54) **VERWENDUNG EINER WINDENERGIEANLAGEN-PRÜFVORRICHTUNG UND VERFAHREN ZUM PRÜFEN EINER WINDENERGIEANLAGE**
USE OF A TEST DEVICE FOR WIND ENERGY INSTALLATIONS AND METHOD FOR TESTING A WIND ENERGY INSTALLATION
UTILISATION D'UN DISPOSITIF DE CONTRÔLE D'ÉOLIENNE ET PROCÉDÉ DE CONTRÔLE D'UNE ÉOLIENNE

(30) Priorität: 03.02.2015 DE 102015201857; 26.08.2015 DE 102015114126
(43) Veröffentlichungstag der Anmeldung: 17.08.2016
(73) Patentinhaber: Wobben Properties GmbH, 26607 Aurich (DE)
(72) Erfinder: Schrobsdorff, Simon, 26556 Eversmeer (DE)
(74) Vertreter: Eisenführ Speiser

(56) Entgegenhaltungen:
- DE-A1-102008 049 629
- DE-A1-102010 060 333
- US-A1- 2009 066 166
- ZHUANG XU ET AL: "Control of Parallel Multirectifiers for a Direct-Drive Permanent-Magnet Wind Power Generator", IEEE TRANSACTIONS ON INDUSTRY APPLICATIONS, IEEE SERVICE CENTER, PISCATAWAY, NJ, US, Bd. 49, Nr. 4, 1. Juli 2013 (2013-07-01), Seiten 1687-1696, XP011520305, ISSN: 0093-9994, DOI: 10.1109/TIA.2013.2258312
- PANNELL G ET AL: "Minimum-Threshold Crowbar for a Fault-Ride-Through Grid-Code-Compliant DFIG Wind Turbine", IEEE TRANSACTIONS ON ENERGY CONVERSION, IEEE SERVICE CENTER, PISCATAWAY, NJ, US, Bd. 25, Nr. 3, 1. September 2010 (2010-09-01), Seiten 750-759, XP011311496, ISSN: 0885-8969
- BAGGU, M.M.: "Advanced control techniques for doubly fed induction generator-based wind turbine converters to improve low voltage ride-through during system imbalances, doctoral dissertation", thesis, 2009, XP055778155,
- Anonymous: "Industrial Power Corruptor - User's Manual IPC-480V-200A, IPC-480V-100A, IPC-480V-50A, IPC-240V-25A", , 1 June 2003 (2003-06-01), pages 1-59, XP055843631,
- KLOSSE, R.: "High-Voltage-Ride-Through Test System Based on Trans- former Switching", The 12th International Workshop on Large-Scale Integration of Wind Power into Power Systems as well as on Transmission Networks for Offshore Wind Power Plants, 2013, XP055778656, London, England
- Yongcheng et al: "Benchmarking of Voltage Sag Generators", The 38th Annual Con- ference of the IEEE Industrial Electronics Society, 2012, XP032281485,

## Beschreibung

Die vorliegende Erfindung betrifft eine Verwendung einer Windenergieanlagen-Prüfvorrichtung und ein Prüfverfahren zum Prüfen einer Windenergieanlage.

Damit eine Windenergieanlage eine entsprechende Zulassung erhält, müssen verschiedene Tests durchgeführt werden, um nachzuweisen, dass die Windenergieanlage allen Anforderungen entspricht. Bei derartigen Tests werden Fehler in einem Energieversorgungsnetzwerk wie beispielsweise eine Unterfrequenz, eine Überfrequenz, eine Über-/Unterspannung, ein Kurzschluss etc. nachgebildet bzw. simuliert und die Reaktion der Windenergieanlage auf einen derartigen Fehler wird erfasst.

DE 10 2008 049 629 A1 beschreibt eine Windenergieanlagen-Prüfeinrichtung zum Erzeugen oder Simulieren von Fehlern in einem Energieversorgungsnetz. Dazu ist die Prüfeinrichtung dazu ausgestaltet, Netzfehler definiert zu erzeugen. Die Prüfeinrichtung weist eine Schalteinrichtung zum Zuschalten einer elektrischen Störkomponente in Bezug auf einen Netzparameter auf. Die Prüfeinrichtung weist einen Spartransformator für die elektrische Störkomponente auf. Das ungestörte Netz des Energieversorgungsunternehmens wird an einen Primärwicklungsanschluss angelegt und der Sekundärwicklungsanschluss wird an ein in Bezug auf den Netzparameter gestörtes Netz ausgegeben. WO 2012/113951 A1 beschreibt eine Verwendung einer Prüfvorrichtung zum Erzeugen von Strom und Spannungswerten, die einem Fehler in einem Energieversorgungsnetz entsprechen. Die Prüfvorrichtung weist eine Transformatoreinheit mit einem Transformator und einer Schalteinheit, einen ersten Anschluss zum Anschließen an eine zu prüfende Windenergieanlage, und einen zweiten Anschluss zum Anschließen an das Energieversorgungsnetz und eine Spuleneinheit auf.

Als weiteren Stand der Technik wird auf die folgenden Dokumente verwiesen: DE 10 2010 060 333 A1, DE 20 2012 001 061 U1, US 2012 / 0 144 909 A1 und EP 2 146 264 A1.

Es ist eine Aufgabe der Erfindung, eine Windenergieanlagen-Prüfvorrichtung vorzusehen, welche eine verbesserte Prüfung einer Windenergieanlage ermöglicht.

Diese Aufgabe wird durch eine Windenergieanlagen-Prüfvorrichtung gemäß Anspruch 1 und durch ein Prüfverfahren nach Anspruch 4 gelöst.

Somit wird eine Verwendung einer Windenergieanlagen-Prüfvorrichtung zum Erzeugen von Strom- und/oder Spannungswerten, die einem Fehler in einem Energieversorgungsnetz entsprechen, vorgesehen. Die Prüfvorrichtung weist eine Transformatoreinheit mit einem Spartransformator und einer Transformator-Schalteinheit, einen ersten Anschluss zum Anschließen an eine zu prüfende Windenergieanlage, einen zweiten Anschluss zum Anschließen an ein Energieversorgungsnetz, eine Spuleneinheit in Reihe zu dem ersten Anschluss und eine Prüfschalteinheit zwischen dem ersten und zweiten Anschluss auf. Die Spuleneinheit ist in Reihe zu dem Spartransformator geschaltet. In einer ersten Betriebsart, nämlich der Normalbetriebsart, wird die Transformator-Schalteinheit geöffnet und die Prüfschalteinheit geschlossen. In einer zweiten Betriebsart, nämlich der Prüfbetriebsart, wird zuerst die Transformator-Schalteinheit geschlossen, so dass ein Kreisstrom fließen kann und die Prüfschalteinheit wird danach geöffnet, so dass kein Kreisstrom mehr fließt und eine Spannungserhöhung an dem ersten Anschluss anliegt.

Die Erfindung betrifft ebenfalls ein Prüfverfahren zum Prüfen einer Windenergieanlage durch Erzeugen von Strom und/oder Spannungswerten, die einen Fehler in einem Energieversorgungsnetz entsprechen, mittels einer Prüfvorrichtung, welche eine Transformatoreinheit mit einem Spartransformator und einer Transformator-Schalteinheit, einen ersten Anschluss zum Anschließen an eine zu prüfende Windenergieanlage, einen zweiten Anschuss zum Anschließen an ein Energieversorgungsnetz, eine Spuleneinheit in Reihe zu dem ersten Anschluss und eine Prüfschalteinheit zwischen dem ersten und zweiten Anschluss aufweist. Die Spuleneinheit ist in Reihe zu dem Spartransformator geschaltet. In einer ersten Betriebsart, nämlich der Normalbetriebsart, wird die Transformator-Schalteinheit geöffnet und die Prüfschalteinheit wird geschlossen. In einer zweiten Betriebsart, nämlich der Prüfbetriebsart, wird die Transformator-Schalteinheit geschlossen, so dass ein Kreisstrom fließen kann. Anschließend kann die Prüfschalteinheit geöffnet werden, so dass kein Kreisstrom mehr fließt und eine Spannungserhöhung an dem ersten Anschluss anliegt.

Gemäß einem nicht beanspruchten Beispiel ist eine Windenergieanlagen-Prüfvorrichtung zum Erzeugen von Strom und/oder Spannungswerten vorgesehen, die einen Fehler in einem Energieversorgungsnetz entsprechen. Die Prüfvorrichtung weist einen Transformator und zwei Transformator-Schalteinheiten auf, welche vor und hinter dem Transformator angeordnet sind. Die Prüfvorrichtung weist einen ersten Anschluss zum Anschließen an eine zu prüfende Windenergieanlage und einen zweiten Anschluss zum Anschließen an ein Energieversorgungsnetz auf. Die Prüfeinheit weist ferner eine Spuleneinheit in Reihe mit dem Transformator und eine Prüfschalteinheit zwischen dem ersten und zweiten Anschluss auf. Die Prüfschalteinheit ist parallel zu der Reihenschaltung aus dem Transformator und der Spuleneinheit angeordnet. In einer ersten Betriebsart, nämlich der normalen Betriebsart sind die zwei Transformator-Schalteinheiten geschlossen und die Prüfschalteinheit ist ebenfalls geschlossen. In einer zweiten Betriebsart, nämlich der Prüfbetriebsart, sind die zwei Transformator-Schalteinheiten zuerst geschlossen, so dass ein Kreisstrom fließt und die Prüfschalteinheit danach geöffnet wird, so dass kein Kreisstrom mehr fließt und eine Spannungserhöhung oder Spannungsabsenkung an dem ersten Anschluss anliegt.

Gemäß einem nicht beanspruchten Beispiel ist eine Windenergieanlage-Prüfvorrichtung zum Erzeugen von Strom und/oder Spannungswerten vorgesehen, die einem Fehler in einem Energieversorgungsnetz entsprechen. Die Prüfvorrichtung weist einen Transformator und eine Transformator-Schalteinheit in Reihe zum Transformator, einen ersten Anschluss zum Anschließen an eine zu prüfende Windenergieanlage, einen zweiten Anschluss zum Anschließen an ein Energieversorgungsnetz, eine Spuleneinheit parallel zu der Reihenschaltung aus Transformator und Transformator-Schalteinheit und eine Prüfschalteinheit zwischen dem ersten und zweiten Anschluss auf. In einer ersten Betriebsart, nämlich der Normalbetriebsart, ist die Transformator-Schalteinheit geöffnet und die Prüfschalteinheit ist geschlossen. In einer zweiten Betriebsart, nämlich der Prüfbetriebsart, ist die Prüfschalteinheit zuerst geöffnet und die Transformator-Schalteinheit ist geschlossen, so dass eine Spannungserhöhung oder Spannungsabsenkung an dem ersten Anschluss anliegt, wobei die Spannungserhöhung oder Spannungsabsenkung beendet wird, wenn die Transformator-Schalteinheit geschlossen wird.

Gemäß einem Aspekt der vorliegenden Erfindung weist die Prüfvorrichtung ein Gehäuse in Form eines Standardcontainers auf.

Gemäß einem weiteren Aspekt der vorliegenden Erfindung ist eine weitere Prüfschalteinheit vorgesehen, welche zwischen dem zweiten Anschluss und der ersten Prüfschalteinheit vorgesehen ist.

Weitere Ausgestaltungen der Erfindung sind Gegenstand der Unteransprüche.

Vorteile und Ausführungsbeispiele der Erfindung werden nachstehend anhand der Zeichnungen näher erläutert.
- Fig. 1: zeigt eine schematische Darstellung einer Windenergieanlage gemäß der Erfindung,
- Fig. 2A: zeigt eine schematische Darstellung einer Prüfanordnung einer Windenergieanlage,
- Fig. 2B: zeigt einen Graphen zur Veranschaulichung der Spannung an einer Windenergieanlage sowie einer Netzspannung,
- Fig. 3A: zeigt eine schematische Darstellung einer Prüfanordnung einer Windenergieanlage gemäß einem ersten Ausführungsbeispiel,
- Fig. 3B: zeigt einen Graphen zur Veranschaulichung der Netzspannung bei einer Prüfanordnung gemäß dem ersten Ausführungsbeispiel,
- Fig. 4A: zeigt eine schematische Darstellung einer Prüfanordnung einer Windenergieanlage gemäß einem zweiten Ausführungsbeispiel,
- Fig. 4B: zeigt einen Graphen zur Veranschaulichung der Netzspannung bei einer Prüfanordnung gemäß dem zweiten Ausführungsbeispiel,
- Fig. 5A: zeigt eine schematische Darstellung einer Prüfanordnung einer Windenergieanlage gemäß einem dritten Ausführungsbeispiel,
- Fig. 5B: zeigt einen Graphen zur Veranschaulichung der Netzspannung bei einer Prüfanordnung gemäß dem dritten Ausführungsbeispiel,
- Fig. 6A: zeigt eine schematische Darstellung einer Prüfanordnung einer Windenergieanlage gemäß einem vierten Ausführungsbeispiel,
- Fig. 6B: zeigt einen Graphen zur Veranschaulichung des Spannungsverlaufs bei der Prüfanordnung gemäß dem vierten Ausführungsbeispiel,
- Fig. 7A: zeigt eine schematische Darstellung einer Prüfanordnung gemäß einem fünften Ausführungsbeispiel,
- Fig. 7B: zeigt einen Graphen zur Veranschaulichung des Spannungsverlaufs bei der Prüfanordnung gemäß dem fünften Ausführungsbeispiel,
- Fig. 8A: zeigt eine schematische Darstellung zur Veranschaulichung einer Prüfanordnung einer Windenergieanlage gemäß einem sechsten Ausführungsbeispiel,
- Fig. 8B: zeigt einen Graphen zur Veranschaulichung eines Spannungsverlaufs bei einer Prüfanordnung gemäß einem sechsten Ausführungsbeispiel,
- Fig. 9: zeigt eine schematische Schnittansicht einer Prüfvorrichtung gemäß einem siebten Ausführungsbeispiel,
- Fig. 10: zeigt ein schematisches Blockschaltbild einer Prüfanordnung einer Windenergieanlage gemäß einem achten Ausführungsbeispiel, und
- Fig. 11: zeigt ein schematisches Schaltbild einer Prüfanordnung für eine Windenergieanlage.

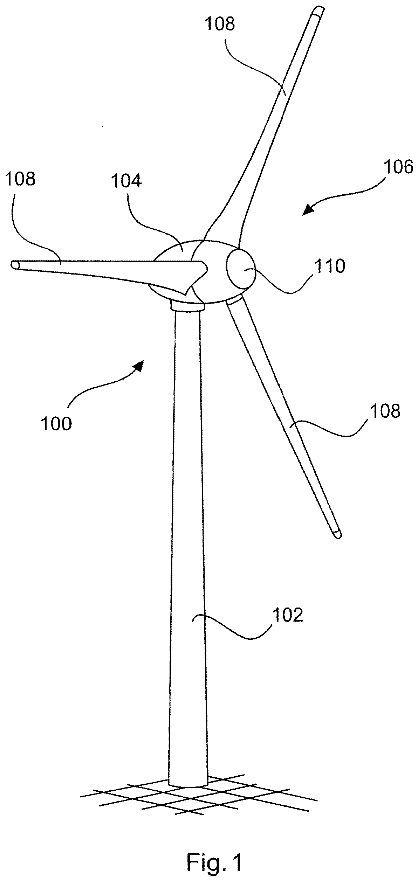

Fig. 1 zeigt eine schematische Darstellung einer Windenergieanlage gemäß der Erfindung. Die Windenergieanlage 100 weist einen Turm 102 und eine Gondel 104 auf dem Turm 102 auf. An der Gondel 104 ist ein aerodynamischer Rotor 106 mit drei Rotorblättern 108 und einem Spinner 110 vorgesehen. Der aerodynamische Rotor 106 wird im Betrieb der Windenergieanlage durch den Wind in eine Drehbewegung versetzt und dreht somit auch einen Rotor oder Läufer eines Generators, welcher direkt oder indirekt mit dem aerodynamischen Rotor 106 gekoppelt ist. Der elektrische Generator ist in der Gondel 104 angeordnet und erzeugt elektrische Energie. Die Pitchwinkel der Rotorblätter 108 können durch Pitchmotoren an den Rotorblattwurzeln 108b der jeweiligen Rotorblätter 108 verändert werden.

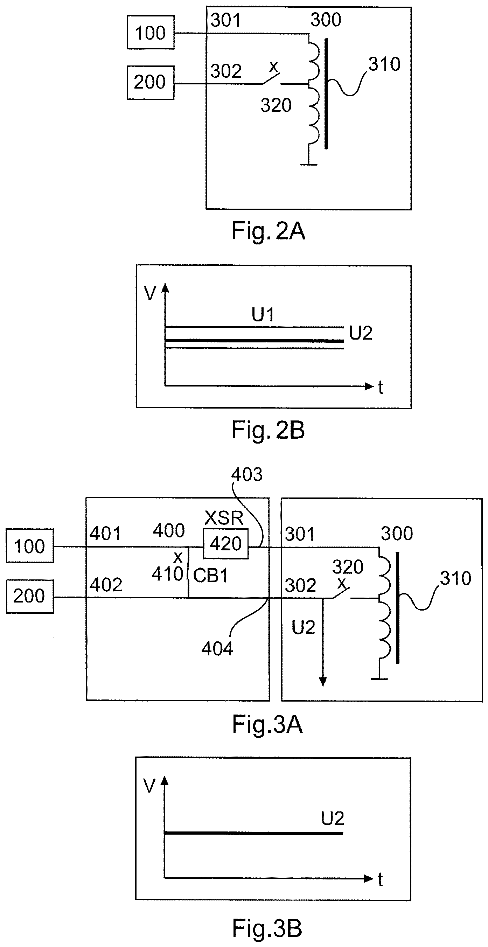

Fig. 2A zeigt eine schematische Darstellung einer Prüfanordnung einer Windenergieanlage. Die Windenergieanlage 100 ist über eine Transformatoreinheit 300 mit einem elektrischen Energieversorgungsnetz 200 gekoppelt. Die Transformatoreinheit 300 weist einen ersten Anschluss 301 und einen zweiten Anschluss 302 auf. Die Windenergieanlage 300 ist an den ersten Anschluss 301 und das elektrische Energieversorgungsnetz 200 ist an den zweiten Anschluss 302 angeschlossen bzw. gekoppelt. Die Transformatoreinheit 300 weist ferner einen (Spar)transformator 310 sowie eine Mittelspannungsschalteinheit 320 auf. Diese Mittelspannungsschalteinheit 320 ist über den zweiten Anschluss 302 mit dem elektrischen Energieversorgungsnetz 200 gekoppelt. Ein Spartransformator ist ein Transformator ohne galvanische Trennung.

Der (Spar)transformator 310 sollte mindestens auf die Nennleistung der Windenergieanlage ausgelegt werden. Der maximale Strom ergibt sich aus der Nennscheinleistung des Transformators bei der kleinsten Spannung beim Unterspannung-Betrieb LVRT (Low Voltage Ride Through). Der Transformator ist (hermetisch) gekapselt und z. B. Öl-gekühlt. Der Transformator weist mehrere Stufen auf. Anzapfungen sind bei Überspannungsbetrieb HVRT (High Voltage Ride Through) bei +5; +10; +15; +25; +30 und beim Unterspannungsbetrieb LVRT bei -3,9; -7,7; -11,6; -15,4; -19,3; -23,1 möglich.

Der Spartransformator kann in einem Standardcontainer, beispielsweise ein 20 oder 40-Fuß Seecontainer, vorgesehen sein.

Mittels der Transformatoreinheit 300 kann eine dauerhafte Spannungserhöhung oder Spannungsabsenkung an der Windenergieanlage 100 simuliert werden bzw. eine dauerhafte Spannungserhöhung oder Spannungsabsenkung kann der Windenergieanlage 100 zu Testzwecken zugeführt werden, um herauszufinden, wie sich die Windenergieanlage in einem Netzfehlerfall verhält.

Fig. 2B zeigt einen Graphen zur Veranschaulichung des Spannungsverlaufs an der Windenergieanlage U1 und die Spannung U2 des elektrischen Energieversorgungsnetzes.

Fig. 3A zeigt eine schematische Darstellung einer Prüfanordnung einer Windenergieanlage gemäß einem ersten Ausführungsbeispiel. In Fig. 3A ist eine Windenergieanlage 100 gezeigt, welche über eine Prüfeinheit 400 mit einer Transformatoreinheit 300 gekoppelt ist. Die Windenergieanlage 100 kann wie in Fig. 1 beschrieben ausgestaltet sein. Die Prüfvorrichtung 400 ist ebenfalls mit dem elektrischen Energieversorgungsnetz 200 gekoppelt. Die Transformatoreinheit 300 gemäß dem ersten Ausführungsbeispiel entspricht der Transformatoreinheit gemäß Fig. 2A und weist einen ersten und zweiten Anschluss 301, 302, einen (Spar)transformator 310 sowie eine Mittelspannungsschalteinheit 320 auf.

Die Prüfvorrichtung 400 weist einen ersten Anschluss 401 zur Kopplung mit der Windenergieanlage 100, einen zweiten Anschluss 402 zur Kopplung mit dem elektrischen Energieversorgungsnetz 200, einen dritten Anschluss 403 zur Kopplung mit dem ersten Anschluss 301 der Transformatoreinheit und einen vierten Anschluss 404 zum Koppeln mit dem zweiten Anschluss 302 der Transformatoreinheit 300 auf.

Die Prüfvorrichtung 400 weist ferner einen Schalter 410 zwischen dem ersten und zweiten Anschluss 401, 402 sowie eine Spule 420 zwischen dem ersten und dritten Anschluss 401, 403 sowie zwischen dem Schalter 410 und dem dritten Anschluss 403 der Prüfvorrichtung 400 auf. In Fig. 3A ist der Schalter 410 der Prüfvorrichtung geschlossen und der Schalter 320 der Transformatoreinheit ist offen, so dass die Netzspannung U2 an dem zweiten Anschluss 320 der Transformatoreinheit 300 anliegt.

In Fig. 3B ist die Netzspannung U2 gezeigt.

Gemäß dem ersten Ausführungsbeispiel (Schalter 410 geschlossen, Schalter 320 offen) entspricht die Netzspannung U2 der Spannung U1 an der Windenergieanlage. Somit entspricht das erste Ausführungsbeispiel einem Normalbetrieb.

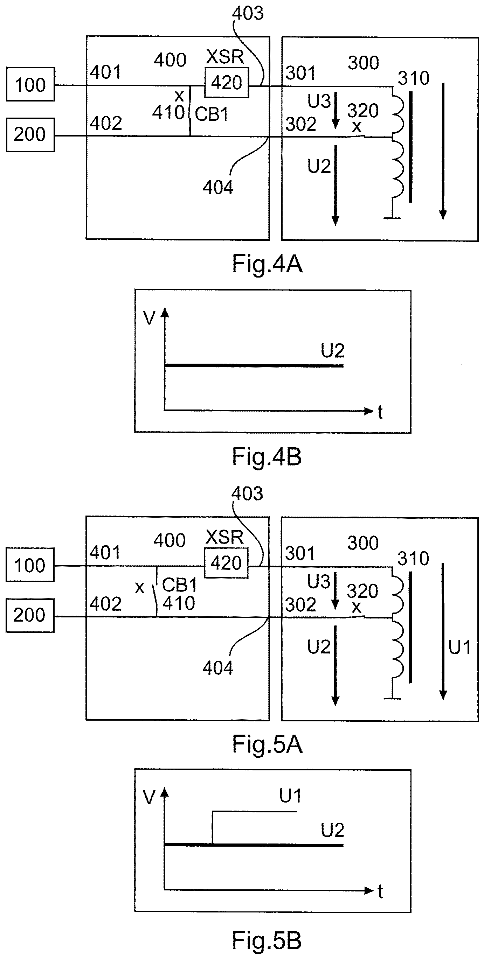

Fig. 4A zeigt eine schematische Darstellung einer Prüfanordnung einer Windenergieanlage gemäß einem zweiten Ausführungsbeispiel. Der Aufbau der Prüfanordnung mit der Windenergieanlage 100, dem Netz 200, der Transformatoreinheit 300 sowie der Prüfvorrichtung 400 entspricht der Anordnung gemäß dem ersten Ausführungsbeispiel von Fig. 3A. Gemäß dem zweiten Ausführungsbeispiel ist der Schalter 410 geschlossen und der Schalter 320 ist ebenfalls geschlossen. Gemäß dem zweiten Ausführungsbeispiel sind somit beide Schalter 410, 420 geschlossen, so dass ein Kreisstrom entsteht, welcher durch die Spannungsdifferenz U3 zwischen U1 und U2 angetrieben wird. Dieser Kreisstrom wird durch die Spule 420 begrenzt und zwar unabhängig von dem Strom, welcher durch die Windenergieanlage 100 zur Verfügung gestellt wird.

Die Höhe des Kreisstromes ist abhängig von der Differenzspannung U3. Wenn die Differenzspannung U3 beispielsweise 10% beträgt (von 20 kV), dann ergibt sich bei einer Spule XSR von 20 Ohm ein Kreisstrom von 60A.

In Fig. 4B ist wiederum die Spannung U2 des elektrischen Energieversorgungsnetzes dargestellt.

Fig. 5A zeigt eine schematische Darstellung einer Prüfanordnung einer Windenergieanlage gemäß einem dritten Ausführungsbeispiel. Hierbei entspricht die Prüfanordnung gemäß dem dritten Ausführungsbeispiel dem Aufbau der Prüfanordnung gemäß dem ersten oder zweiten Ausführungsbeispiel. Gemäß dem dritten Ausführungsbeispiel ist der Schalter 410 geöffnet, während der Schalter 320 geschlossen ist. Durch Öffnen des Schalters 410 kommt es zu einer Spannungserhöhung oder Spannungsabsenkung an der Windenergieanlage, so dass entsprechende Tests (Überspannung: High voltage ride through HVRT; Unterspannung: Low voltage ride through LVRT) durchgeführt werden können.

In Fig. 5B ist eine Spannungserhöhung der Spannung U1 an der Windenergieanlage in Abhängigkeit der Betriebsposition des Schalters 410 dargestellt.

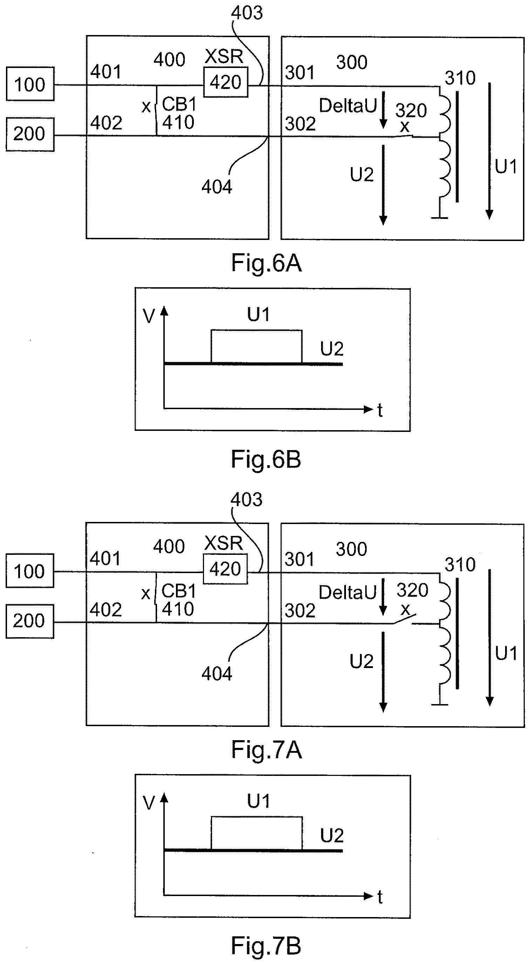

Fig. 6A zeigt eine schematische Darstellung einer Prüfanordnung einer Windenergieanlage gemäß einem vierten Ausführungsbeispiel. Der Aufbau der Prüfanordnung gemäß dem vierten Ausführungsbeispiel entspricht dem Aufbau der Prüfanordnung gemäß dem ersten, zweiten oder dritten Ausführungsbeispiel. Gemäß dem vierten Ausführungsbeispiel wird der Schalter 410 geschlossen, so dass die Spannung U1 an der Windenergieanlage der Spannung U2 des elektrischen Energieversorgungsnetzes 200 entspricht. In Fig. 6B ist der Verlauf der Netzspannung U2 sowie der Verlauf der Spannung U1 an der Windenergieanlage 100 dargestellt.

Fig. 7A zeigt eine schematische Darstellung einer Prüfanordnung gemäß einem fünften Ausführungsbeispiel. Der Aufbau der Prüfanordnung entspricht dem Aufbau der Prüfanordnung gemäß dem ersten, zweiten, dritten oder vierten Ausführungsbeispiel. Gemäß dem fünften Ausführungsbeispiel wird der Schalter 320 geöffnet, so dass der Prüfvorgang beendet ist. Damit entsprechen die Schalterpositionen der Schalter 410 und 320 gemäß dem fünften Ausführungsbeispiel den Schalterpositionen gemäß dem zweiten Ausführungsbeispiel.

In Fig. 7B ist der Verlauf der Netzspannung U2 sowie der Verlauf der Spannung U1 an der Windenergieanlage dargestellt.

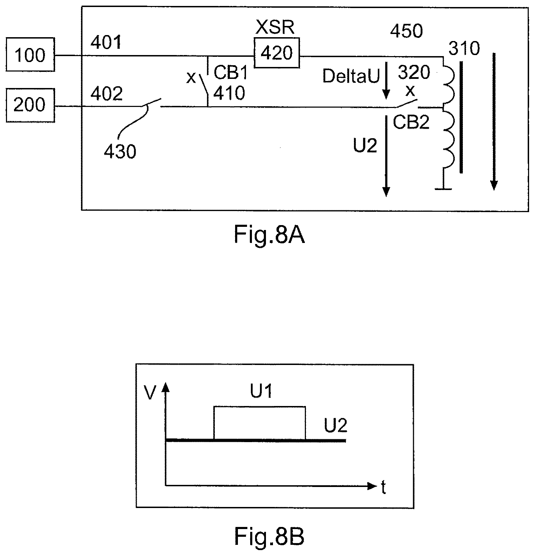

Fig. 8A zeigt eine schematische Darstellung einer Prüfanordnung einer Windenergieanlage gemäß einem sechsten Ausführungsbeispiel. Gemäß dem sechsten Ausführungsbeispiel ist eine Prüfeinheit 450 gezeigt, welche einen Spartransformator 310, eine Mittelspannungsschalteinheit 320, eine Spule 420, einen Schalter 410 sowie einen zweiten Schalter 430 aufweist.

In Fig. 8B ist der Verlauf der Netzspannung U2 sowie der Spannung U1 an der Windenergieanlage dargestellt.

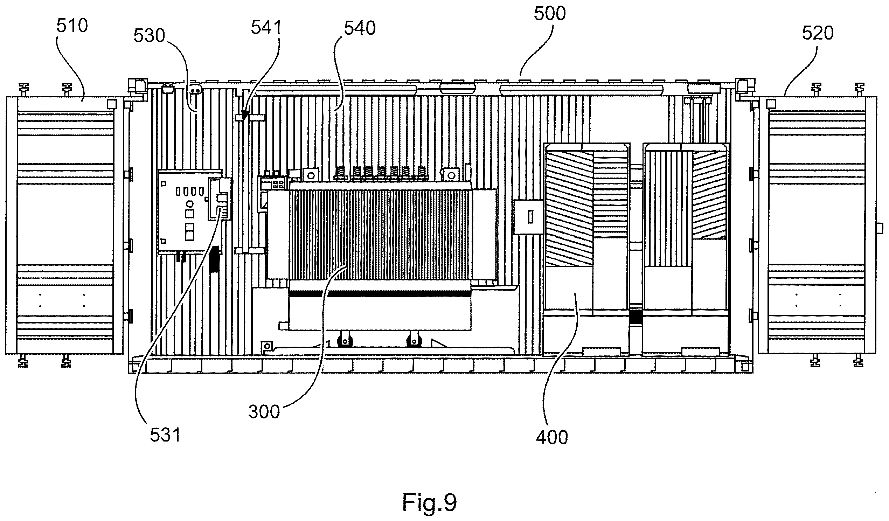

Fig. 9 zeigt einen schematischen Querschnitt einer Prüfvorrichtung gemäß einem siebten Ausführungsbeispiel. Die Prüfvorrichtung 400 ist in einem Standardcontainer 500 angeordnet. Der Standardcontainer 500 weist eine erste und zweite Tür 510, 520 auf. Ferner weist der Standardcontainer 500 einen Mittelspannungsbereich 540 sowie einen davon durch eine Wand 541 getrennten Bereich 530 auf, in welchem keine Mittelspannung vorhanden ist. In dem Bereich 530 kann eine Fernbedienung 531 vorgesehen sein, um den Betrieb der Prüfvorrichtung zu steuern. Die Prüfvorrichtung 400 gemäß einem der Ausführungsbeispiele 1 bis 5 kann in dem Mittelspannungsbereich 540 angeordnet sein.

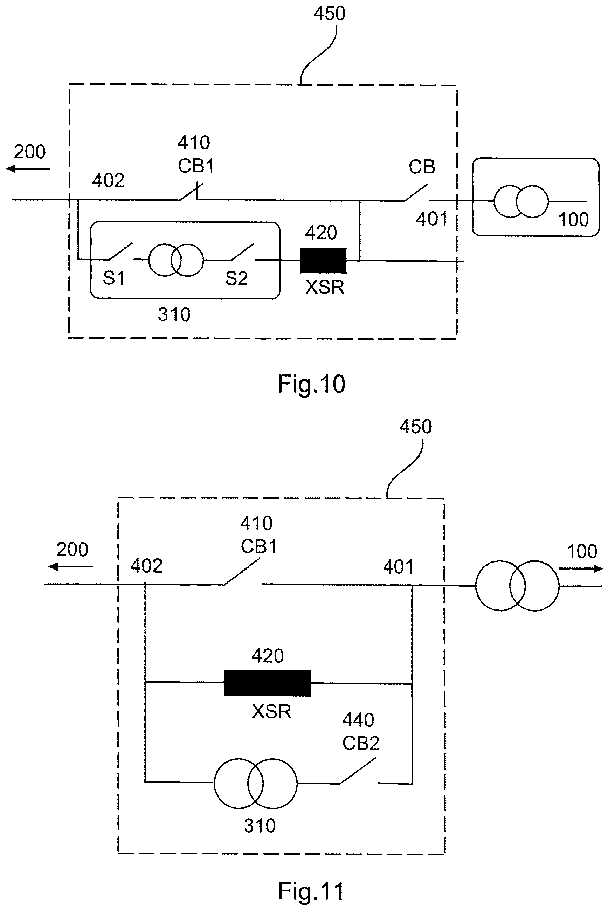

Fig. 10 zeigt ein schematisches Blockschaltbild einer Prüfanordnung einer Windenergieanlage gemäß einem achten Ausführungsbeispiel. Die Prüfanordnung 405 weist einen Spartransformator 310, einen ersten und zweiten Schalter S1, S2 (vor und hinter dem Spartransformator 310), eine Spule 420, XSR sowie zwei Schalter, insbesondere Schutzschalter, auf. Die Prüfeinheit kann mit einer Windenergieanlage 100 und dem Energieversorgungsnetz 200 gekoppelt werden. Insbesondere ist die Prüfeinheit 450 mittels eines ersten Anschlusses 401 mit einer Windenergieanlage 100 koppelbar. Ferner ist die Prüfeinheit 450 über einen zweiten Anschluss 402 mit einem elektrischen Energieversorgungsnetz 200 koppelbar. Zwischen dem ersten und zweiten Anschluss 401, 402 ist ein erster Schutzschalter bzw. Schalter 410 sowie ein weiterer Schutzschalter CB vorgesehen. Der zweite Schutzschalter CB ist mit dem ersten Anschluss gekoppelt.

Parallel zu dem Schutzschalter 410 ist ein Spartransformator 310 mit einem ersten und zweiten Schalter S1, S2 und einer Spule 420 geschaltet.

Gemäß dem achten Ausführungsbeispiel ist der Spartransformator 310 in Reihe mit der Spule 420 geschaltet. Wenn die Schalter S1, S2 geschlossen sind und der Schalter 410 ebenfalls geschlossen ist, dann kann ein Kreisstrom durch den Transformator und die Spule fließen. Wenn die beiden Schalter S1, S2 geschlossen sind und der Schalter 410 geöffnet ist, dann ist der Kreisstrom 0 und ein Überspannungstestfall (High Voltage Ride Through) kann durchgeführt werden. Die Spannungsanhebung ist hierbei abhängig von der Stufe des Transformators.

Wenn anschließend beide Schalter S1, S2 geschlossen sind und der Schalter 410 ebenfalls geschlossen ist, dann kann wieder ein Kreisstrom fließen.

Fig. 11 zeigt ein schematisches Schaltbild einer Prüfanordnung für eine Windenergieanlage. Das Schaltbild ist nicht Gegenstand der unabhängigen Ansprüche. Der Spartransformator 310 und die Spule 420 sind parallel zu einem Schutzschalter 410 vorgesehen. In Reihe zu dem Spartransformator 310 ist ein weiterer Schutzschalter 440 vorgesehen. Die Prüfungsanordnung 450 kann mit einer Windenergieanlage 100 und einem elektrischen Energieversorgungsnetz 200 gekoppelt werden.

Der Versuchsablauf wird nachfolgend erläutert:
Im Normalbetrieb ist der Schutzschalter 410 geschlossen und der Schutzschalter 440 ist offen. Wenn der Schutzschalter 410 geöffnet wird und Schutzschalter 440 offen ist, wird die Windenergieanlage 100 mit der vorgeschalteten Spule 420 betrieben. Es fließt kein Kreisstrom. Wenn der Schutzschalter 440 geschlossen wird, fließt ein Kreisstrom in Stromkreis Spartrafo 310 und Spule 420 mit einer Spannungsanhebung / Absenkung am Anschluss 401. Wenn der Schutzschalter 440 geöffnet wird, wird die WEA wieder über die Spule 420 betrieben und die Über- / Unterspannungsprüfung ist beendet. Wenn der Schutzschalter 410 geschlossen wird, ist die Anlage wieder im Normalbetrieb.

In den Figuren 4A, 5A, 6A, 7A und 8A ist jeweils eine Reihenschaltung aus der Spule 240 und dem Spartransformator 310 vorhanden. Dies hat zur Folge, dass eine Spannung über der Spule 420 abfallen kann. Insbesondere wenn mehrere Windenergieanlagen geprüft werden, kann dieser Spannungsabfall über der Spule 420 zu berücksichtigen sein. Die Prüfungsanordnung gemäß Fig. 11 stellt eine Parallelschaltung der Spule 420 sowie des Spartransformators 310 dar. Durch diese Parallelschaltung kann ein Spannungsabfall über der Spule 420 vermieden werden.

## Patentansprüche

1. Verwendung einer Windenergieanlagen-Prüfvorrichtung (400) zum Erzeugen von Strom- und/oder Spannungswerten, die einem Fehler in einem Energieversorgungsnetz (200) entsprechen, wobei die Windenergieanlagen-Prüfvorrichtung eine Transformatoreinheit (200) mit einem Spartransformator (310) und einer Transformator-Schalteinheit (320), einen ersten Anschluss (401) zum Anschließen an eine zu prüfende Windenergieanlage (100), einen zweiten Anschluss (402) zum Anschließen an ein Energieversorgungsnetz (200), eine Spuleneinheit (420) in Reihe zu dem ersten Anschluss (401), und eine Prüfschalteinheit (410) zwischen dem ersten und zweiten Anschluss (401, 402) aufweist,
wobei die Spuleneinheit (420) in Reihe zu dem Spartransformator (310) geschaltet ist,
wobei in einer ersten Betriebsart, nämlich der Normalbetriebsart, die Transformator-Schalteinheit (320) geöffnet ist und die Prüfschalteinheit (410) geschlossen ist,
wobei in einer zweiten Betriebsart, nämlich der Prüfbetriebsart, die Transformator-Schalteinheit (320) zuerst geschlossen wird, so dass ein Kreisstrom fließt und die Prüfschalteinheit (410) danach geöffnet wird, so dass kein Kreisstrom mehr fließt und eine Spanungserhöhung an dem ersten Anschluss (401) anliegt.

2. Verwendung einer Windenergieanlagen-Prüfvorrichtung (400) nach Anspruch 1, wobei die Windenergieanlagen-Prüfvorrichtung ein Gehäuse (500) in Form eines StandardContainers aufweist.

3. Verwendung einer Windenergieanlagen-Prüfvorrichtung (400) nach einem der Ansprüche 1 bis 2, wobei die Windenergieanlagen-Prüfvorrichtung eine zweite Prüfschalteinheit (430) zwischen dem zweiten Anschluss (402) und der ersten Prüfschalteinheit (410) aufweist.

4. Prüfverfahren zum Prüfen einer Windenergieanlage durch Erzeugen von Strom- und/oder Spannungswerten, die einem Fehler in einem Energieversorgungsnetz (200) entsprechen, mittels einer Prüfvorrichtung (400), welche eine Transformatoreinheit (200) mit einem Spartransformator (310) und einer Transformator-Schalteinheit (320), einen ersten Anschluss (401) zum Anschließen an eine zu prüfende Windenergieanlage (100), einen zweiten Anschluss (402) zum Anschließen an ein Energieversorgungsnetz (200), eine Spuleneinheit (420) in Reihe zu dem ersten Anschluss (401) und eine Prüfschalteinheit (410) zwischen dem ersten und zweiten Anschluss (401, 402) aufweist, wobei die Spuleneinheit (420) in Reihe zu dem Spartransformator (310) geschaltet ist, mit den Schritten:
in einer ersten Betriebsart, nämlich der Normalbetriebsart, Öffnen der Transformatorschalteinheit (320) und Schließen der Prüfschalteinheit (410), und
in einer zweiten Betriebsart, nämlich der Prüfbetriebsart, Schließen der Transformator-Schalteinheit (320), so dass ein Kreisstrom fließt, und
anschließendes Öffnen der Prüfschalteinheit (410), so dass kein Kreisstrom mehr fließt und eine Spannungserhöhung an dem ersten Anschluss (401) anliegt.

## Claims

1. Use of a wind turbine test device (400) for producing current and/or voltage values which correspond to an error in an energy supply network (200), wherein the wind turbine test device has a transformer unit (200) having an autotransformer (310) and a transformer switching unit (320), a first connection (401) for connecting to a wind turbine (100) which is intended to be tested, a second connection (402) for connecting to an energy supply network (200), a coil unit (420) in series with the first connection (401), and a test switching unit (410) between the first and second connections (401, 402),
wherein the coil unit (420) is connected in series to the autotransformer (310),
wherein, in a first operating mode, that is to say, normal operating mode, the transformer switching unit (320) is open and the test switching unit (410) is closed,
wherein, in a second operating mode, that is to say, the test operating mode, the transformer switching unit (320) is first closed so that a circular current flows and the test switching unit (410) is subsequently opened so that circular current no longer flows and a voltage increase is applied at the first connection (401).

2. Use of a wind turbine test device (400) according to claim 1, wherein the wind turbine test device has a housing (500) in the form of a standard container.

3. Use of a wind turbine test device (400) according to claim 1 or claim 2, wherein the wind turbine test device has a second test switching unit (430) between the second connection (402) and the first test switching unit (410).

4. Test method for testing a wind turbine by producing current and/or voltage values which correspond to an error in an energy supply network (200), by means of a test device (400) which has a transformer unit (200) having an autotransformer (310) and a transformer switching unit (320), a first connection (401) for connecting to a wind turbine (100) which is intended to be tested, a second connection (402) for connecting to an energy supply network (200), a coil unit (420) in series with the first connection (401) and a test switching unit (410) between the first and second connections (401, 402),
wherein the coil unit (420) is connected in series to the autotransformer (310), having the steps of:
in a first operating mode, that is to say, the normal operating mode, opening the transformer switching unit (320) and closing the test switching unit (410), and,
in a second operating mode, that is to say, the test operating mode, closing the transformer switching unit (320) so that a circular current flows, and
subsequently opening the test switching unit (410) so that circular current no longer flows and a voltage increase is applied at the first connection (401).

## Revendications

1. Utilisation d'un dispositif de contrôle d'éoliennes (400) pour générer des valeurs de courant et/ou de tension, qui correspondent à une erreur dans un réseau d'alimentation en énergie (200), dans laquelle le dispositif de contrôle d'éoliennes présente une unité à transformateur (200) avec un autotransformateur (310) et une unité de commutation de transformateur (320), une première borne (401) destinée à être raccordée à une éolienne (100) à contrôler, une deuxième borne (402) destinée à être raccordée à un réseau d'alimentation en énergie (200), une unité de bobine (420) alignée par rapport à la première borne (401), et une unité de commutation de contrôle (410) entre la première et la deuxième borne (401, 402),
dans laquelle l'unité de bobine (420) est branchée de manière alignée par rapport à l'autotransformateur (310),
dans laquelle dans un premier mode de fonctionnement, à savoir le mode de fonctionnement normal, l'unité de commutation de transformateur (320) est ouverte et l'unité de commutation de contrôle (410) est fermée,
dans laquelle dans un deuxième mode de fonctionnement, à savoir le mode de fonctionnement de contrôle, l'unité de commutation de transformateur (320) est dans un premier temps fermée de sorte qu'un courant circulant circule et l'unité de commutation de contrôle (410) est ensuite ouverte de sorte qu'aucun courant circulant ne circule plus et une augmentation de tension est appliquée sur la première borne (401).

2. Utilisation d'un dispositif de contrôle d'éoliennes (400) selon la revendication 1, dans laquelle le dispositif de contrôle d'éoliennes présente un boîtier (500) sous la forme d'un conteneur standard.

3. Utilisation d'un dispositif de contrôle d'éoliennes (400) selon l'une quelconque des revendications 1 à 2, dans laquelle le dispositif de contrôle d'éoliennes présente une deuxième unité de commutation de contrôle (430) entre la deuxième borne (402) et la première unité de commutation de contrôle (410) .

4. Procédé de contrôle pour contrôler une éolienne en générant des valeurs de courant et/ou de tension, qui correspondent à une erreur dans un réseau d'alimentation en énergie (200), au moyen d'un dispositif de contrôle (400), lequel présente une unité à transformateur (200) avec un autotransformateur (310) et une unité de commutation de transformateur (320), une première borne (401) destinée à être raccordée à une éolienne (100) à contrôler, une deuxième borne (402) destinée à être raccordée à un réseau d'alimentation en énergie (200), une unité de bobine (420) alignée par rapport à la première borne (401) et une unité de commutation de contrôle (410) entre la première et la deuxième borne (401, 402), dans lequel l'unité de bobine (420) est branchée de manière alignée par rapport à l'autotransformateur (310), avec les étapes :
d'ouverture de l'unité de commutation de transformateur (320) et de fermeture de l'unité de commutation de contrôle (410) dans un premier mode de fonctionnement, à savoir le mode de fonctionnement normal, et
de fermeture de l'unité de commutation de transformateur (320) dans un deuxième mode de fonctionnement, à savoir le mode de fonctionnement de contrôle, de sorte qu'un courant circulant circule, et
d'ouverture consécutive de l'unité de commutation de contrôle (410) de sorte qu'aucun courant circulant ne circule plus et qu'une augmentation de tension soit appliquée au niveau de la première borne (401).
